# EUROPEAN PATENT SPECIFICATION

(11) **EP 3 419 403 B1**
(45) Date of publication and mention of the grant of the patent: **09.10.2024**
(21) Application number: 18188154.1
(22) Date of filing: 13.07.2012
(51) Int. Cl.: H05K 13/02

(54) **COMPONENT MOUNTING SYSTEM**
KOMPONENTENMONTAGESYSTEM
SYSTÈME DE MONTAGE DE COMPOSANTS

(43) Date of publication of application: 26.12.2018
(62) Divisional of application: 12880897.9
(73) Proprietor: FUJI Corporation, Chiryu Aichi (JP)
(72) Inventor: KAWAI, Hidetoshi, Chiryu, Aichi (JP)
(74) Representative: Grünecker Patent- und Rechtsanwälte PartG mbB

(56) References cited:
- EP-A1- 2 869 681
- JP-A- H0 575 293
- JP-A- H07 176 892
- JP-A- S61 256 799
- US-A- 5 319 846
- US-A- 5 930 140
- US-A1- 2006 196 045

## Description

### Technical Field

The present invention relates to a component mounting system by which component supply to multiple mounter modules is performed automatically.

### Background Art

For a component mounting system comprising multiple mounter modules, a component storage cabinet which stores tape feeders or component trays housing multiple components is provided at a location separated from the mounter modules, such that many tape feeders and so on can be stored in the storage shelf provided in this component storage cabinet.

And, when components need to be supplied to a mounter module, the tape feeder and so on which houses the required components is selected from the component storage cabinet by an operator, and the tape feeder and so on is moved by an operator to the mounter module which requires component supply and loaded to the component supply device of the mounter module. By doing this, even if a component runs out at a mounter module, it is possible to continue component supply by switching component supply to the newly loaded tape feeder and so on, such that mounting work is not interrupted. This kind of component mounting system is disclosed in patent literature 1. Further examples of component mounting systems are disclosed in EP 2 869 681 A1, US 2006/196045 A1, US 5 319 846 A, JP H05 75293 A, JP S61 256799 A and JP H07 176892 A.

### Citation List

### Patent Literature

Patent Literature 1: Japanese Unexamined Patent Application Publication Number 2012-43886

### Summary of Invention

### Problem to be Solved by the Invention

However, for the component mounting system disclosed in patent literature 1, because the work of component supply and so on must be performed by operators, production cannot be continued without stopping the production line unless one or multiple operators are always stationed at the production line, which means there is the problem that it is not possible to achieve personnel reductions or automation.

The present invention solves the above current problems and its object is to provide a component mounting system which can perform component supply automatically by a supply device which can travel between a component storage cabinet and multiple mounter modules.

### Means for Solving the Problem

The problem is solved by the features of independent claim 1. Preferred embodiments are laid down in the dependent claims.

### Effects of the Invention

According to the present invention, component supply members can be supplied to multiple mounter modules and collected from the multiple mounter modules by a supply device which is conveyable between a component storage cabinet and the multiple mounter modules, which means that the required components can be supplied automatically and efficiently, and personnel reduction and automation are possible.

### Brief Description of Drawings

[FIG. 1] This is a schematic top view showing the overall component mounting system of the first embodiment of the present invention.
[FIG. 2] This is a schematic top view showing the mounter module.
[FIG. 3] This is a diagram showing the relationship between the supply device and the mounter module.
[FIG. 4] This is a perspective view of the mounter module showing an example of the feeder supply unit which constitutes the supply device.
[FIG. 5] This is a perspective view of the mounter module showing an example of the tray supply unit which constitutes the supply device.
[FIG. 6] This is a diagram showing the indexing mechanism of the feeder supply unit.
[FIG. 7] This is a diagram showing the barcode reader for reading the barcodes of tape feeders or trays.
[FIG. 8] This is a block diagram of the control device which controls the mounter modules.
[FIG. 9] This is a perspective view showing the supply device of the second embodiment of the present invention.
[FIG. 10]
   This is a diagram showing the moving device which moves the moving platform.
[FIG. 11]
   This is a diagram showing the positioning means for deciding the position of the unmanned conveyance cart.
[FIG. 12]
   This is a schematic top view showing the overall component mounting system of the third embodiment of the present invention.
[FIG. 13]
   This is a diagram showing the relationship between the supply device and the mounter module of the fourth embodiment of the present invention.

### Description of Embodiments

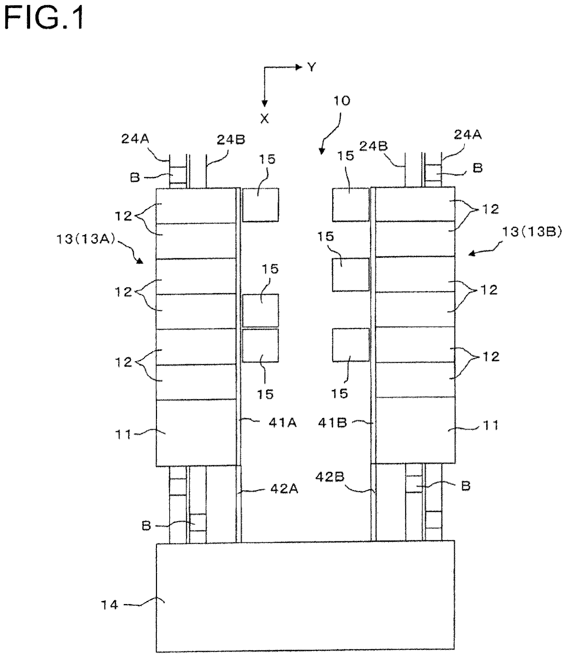

The following describes embodiments of the present invention based on the figures. FIG. 1 shows a component mounting system 10 of the first embodiment of the present invention, in which the component mounting system 10 comprises work modules 13 consisting of a printer module 11 for printing solder onto a circuit board B and multiple mounter modules 12 which mount electronic components (hereafter referred to simply as components) onto the circuit board B, a component storage cabinet 14 for storing many different types of components, and multiple supply devices 15 for supplying components and collecting components between these work modules 13 and the component storage cabinet 14.

The printer module 11 and the multiple mounter modules 12 which constitute the work modules 13 are arranged along the conveyance direction (X-axis direction) of the circuit board B. The work modules 13 are provided in two rows facing each other spaced apart at a predetermined distance in the Y-axis direction which is perpendicular to the X-axis direction. Each of the multiple supply devices 15 is provided such that each of them can travel along each of the two rows of the work modules 13 (hereafter referred to as the first work module 13A and the second work module 13B) respectively.

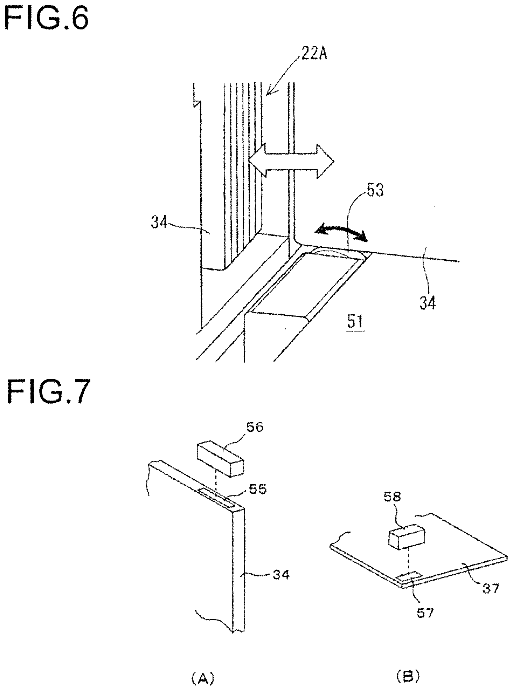

The component storage cabinet 14 is provided in a position separated in the X-axis direction with respect to the first and the second work modules 13A and 13B. Multiple tape feeders 34 (refer to FIG. 7 [A]) housing different types of components or multiple component trays 37 (refer to FIG. 7 [B]) housing different types of components are stored in the component storage cabinet 14 arranged in storage shelves which are omitted from the figures, and the tape feeders 34 or the component trays 37 housing the required components are supplied to the supply devices 15 by an operator.

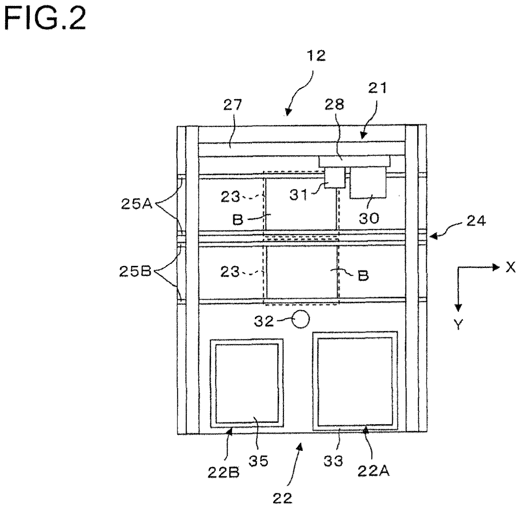

Each of the multiple mounter modules 12, as shown in FIG. 2, is equipped with a component mounter device 21, a component supply device 22, a board holding device 23 and a board conveyance device 24.

The board conveyance device 24 has two rows of belt conveyors 25A and 25B for conveying circuit boards B in the X-axis direction, and conveys the circuit boards B along these belt conveyors 25Aand 25B, and loads and unloads the circuit boards B onto and from a board holding device 23. The board holding device 23 is equipped with a board supporting device for supporting from below a circuit board B which has been loaded by the board conveyance device 24, and a clamping device for clamping the circuit board B in position.

The component mounter device 21 is equipped with a Y-axis slide 27 supported movably in the Y-axis direction in a position above the board holding device 23, an X-axis slide 28 which is supported movably in the X-axis direction on the Y-axis slide 27, and a mounting head 30 which is attached on the X-axis slide 28. Although not shown in the figure, a suction nozzle for picking up and holding components is provided on the mounting head 30. The Y-axis slide 27 and the X-axis slide 28 are moved by an X-axis direction moving device and a Y-axis direction moving device respectively each of which uses a servo motor with encoder as a drive source, such that the mounting head 30 can be moved to any position in the XY plane.

A board imaging device 31 including a CCD camera is provided on the X-axis slide 28, and the board imaging device 31 captures images of board position reference marks and board ID marks provided on the circuit board B which has been positioned on the board holding device 23 and acquires board position reference information and board ID information. Then, position correction is performed for the mounting head 30 in the XY direction with respect to the circuit board B based on the board position reference information acquired by the board imaging device 31, and component mounting work is controlled based on the board ID information acquired by the board imaging device 31.

Numeral 32 is a component imaging device including a CCD camera, and the component imaging device 32 captures an image of a component held on a suction nozzle of the mounting head 30 during movement from the component supply device 22 to above the circuit board B. Then, the pickup condition of the component being held on the suction nozzle and the center deviation of the component with respect to the center of the suction nozzle are detected, and the movement amount in the XY direction of the mounting head 30 are corrected based on the center deviation, such that mounting can be performed with the component at a specified orientation and at specified coordinates on the circuit board B.

The component supply device 22, as an example, includes a feeder type component supply device 22Aand a tray type component supply device 22B, and the feeder type component supply device 22A is equipped with multiple tape feeders 34 functioning as component supply members which are removably attached to a feeder support platform 33, and these multiple tape feeders 34 are lined up in the X-axis direction. A tape housing many components regularly spaced is wound on a tape feeder 34, and by intermittently indexing the tape using a sprocket moved by a motor not shown in the figures which is provided inside of the tape feeder 34, it is possible to consecutively supply components to a specified component supply position.

Further, each of the tape feeders 34 is such that it can be removably attached to a slot provided in the feeder support platform 33, and when the tape feeder 34 is attached to the feeder support platform 33, a connector which is omitted from the figure is connected, and electricity is supplied to the tape feeder 34 from the feeder support platform 33, and management information such as the ID of the tape feeder 34 and control signals (component request signal, component supply complete signal and so on) which are required are transmitted between the control section of the tape feeder 34 and the control section of the feeder support platform 33.

On the other hand, the tray type component supply device 22B is equipped with a housing 35 which houses a stocker which is omitted from the figure such that the stocker can be raised/lowered. Provided in the stocker is multiple tray storage shelves on which are established in parallel in the vertical direction multiple component trays 37 acting as component supply members in which are housed many components, and each of the component trays 37 stored in these tray storage shelves is able to be pulled out from the stocker in the Y-axis direction and positioned at a component supply position.

The above feeder type component supply device 22Aand the tray type component supply device 22B are both known items, and for the feeder type component supply device 22A, for example, the technology disclosed in Japanese Unexamined Patent Application Publication No. 2012-104635 applied for by the same applicant as this application can be used, and for the tray type component supply device 22B, the technology disclosed in Japanese Unexamined Patent Application Publication No. 2009-147197 applied for by the same applicant as this application can be used.

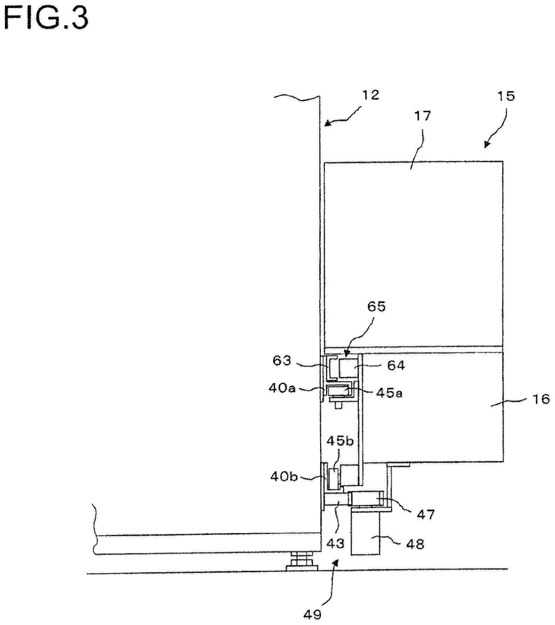

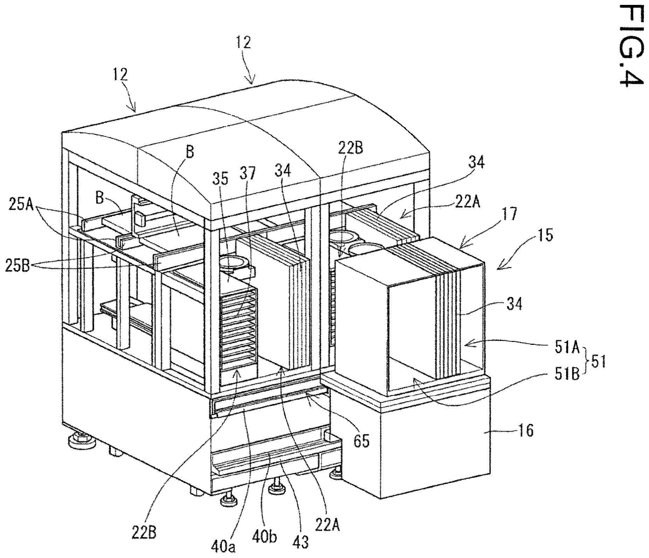

The supply device 15, as shown in FIG. 3 and FIG. 4, has a traveling platform 16 which can travel along each work module 13Aand 13B, and a supply unit 17 loaded on the traveling platform 16. In order to run the traveling platform 16 of the supply device 15 along each work module 13A and 13B, on the front surface of each printer module 11 and multiple mounter modules 12 which constitute the first and the second work modules 13A, upper section and lower section guide rails 40a and 40b formed with a U-shape cross section are attached along the conveyance direction (X-axis direction) of the circuit board B.

By this, when the printer module 11 and the multiple mounter modules 12 are arranged at a predetermined interval along the conveyance direction of the circuit board B, each upper section guide rail 40a and each lower section guide rail 40b attached to an adjacent printer module 11 and mounter module 12 are connected to each other with a slight gap, with first guide rail mechanisms 41A and 41B (refer to FIG. 1) formed in a straight line connected in the conveyance direction of the circuit board B.

Also, between each end of the first guide rail mechanisms 41A and 41B and the component storage cabinet 14, second guide rail mechanisms 42A and 42B connected to the above first guide rail mechanisms 41A and 41B are provided on the floor.

Also, a rack 43 acting as a first engaging body is attached to the front surface of the printer module 11 and each mounter module 12 parallel to the first guide rail mechanisms 41Aand 41B. The rack 43 extends into the component storage cabinet 14 parallel to the second guide rail mechanisms 42Aand 42B.

As shown in FIG. 3, upper section follower rollers 45a which rollably engage with the side surface of the upper section guide rail 40a, and lower section follower rollers 45b which rollably engage with the bottom surface of the lower section guide rail 40b are rotatably supported on each traveling platform 16 of the supply devices 15. Multiple of these upper section and lower section follower rollers 45a and 45b are provided at a regular interval in the traveling direction with most of the weight of the supply device 15 being borne by the lower section follower rollers 45b which engage with the lower section guide rail 40b, and the orientation and Y-direction position of the traveling platform 16 mostly being controlled by the upper section follower rollers 45a which engage with the upper section guide rail 40a.

Also, a pinion 47 acting as the second engaging body which engages with the rack 43 is rotatably supported on each traveling platform 16, and a motor 48 for rotating the pinion 47 is fixed to the traveling platform 16. Rotation is controlled and electrical power is supplied to the motor 48 from the work module 13A or 13B by a contactless transmission device 65 mentioned below. Here, it is acceptable to use a chain instead of a rack as the first engaging body 43 and a sprocket wheel instead of the pinion 47 as the second engaging body 47.

By this, when the pinion 47 which engages the rack 43 is rotated by the motor 48, the traveling platform 16 is conveyed between the component storage cabinet 14 and each of the work modules 13 guided by the first and the second guide rail mechanisms 41A, 41B, 42A, and 42B. In other words, the motor 48 functions as the drive motor for making the traveling platform 16 move. Conveyance means 49 for conveying the supply device 15 includes the above guide rail mechanisms 41A, 41B, 42A, and 42B, the drive motor 48, the rack 43, the pinion 47 and so on.

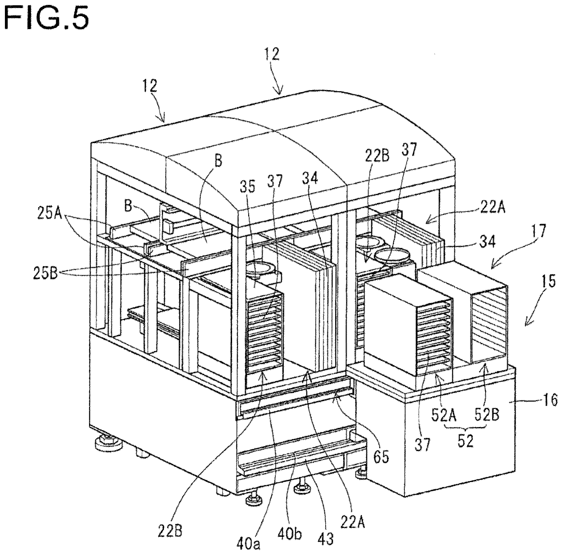

The supply unit 17 loaded on the traveling platform 16 of the supply device 15, as shown in FIG. 4 and FIG. 5, comes in two types, a feeder supply unit 51 for holding tape feeders 34 and a tray supply unit 52 for holding component trays 37, and on the multiple traveling platforms 16 one of either feeder supply unit 51 or tray supply unit 52 is loaded.

With a feeder supply unit 51, a feeder supply section 51A which is capable of housing multiple tape feeders 34 and which supplies these tape feeders 34 to the feeder support platform 33 of the mounter module 12, and a feeder collection section 51B which is capable of housing multiple tape feeders 34 and which collects tape feeders 34 from the feeder support platform 33 of the mounter module 12, are lined up in the traveling direction of the traveling platform 16.

The feeder supply section 51A supports multiple tape feeders 34 lined up in the X-axis direction, and these tape feeders 34 are supported such that they can be moved in the Y-axis direction. The feeder supply section 51A, as shown in FIG. 6, is provided with a feeder indexing mechanism which includes an indexing roller 53 which contacts the bottom surface of each tape feeder 34, and the tape feeder 34 is indexed out from the feeder supply section 51A in the Y-axis direction by the rotation of the indexing roller 53 such that it can be loaded onto an empty slot of the feeder type component supply device 22A of the mounter module 12.

In the same way, the same type of feeder indexing mechanism as above is provided in the feeder collection section 51B too, and the tape feeder 34 which should be collected from the feeder type component supply device 22A of the mounter module 12 is pulled out by this indexing mechanism such that it can be collected in the feeder collection section 51B.

In this case, although not shown in the figure, a locking mechanism for locking and unlocking the tape feeder 34 is provided on the feeder support platform 33 of the feeder type component supply device 22A, and, by the locking operation of this locking mechanism, the tape feeder 34 is taken onto the feeder support platform 33 and locked and also connected by a connector. Conversely, by the unlocking operation of this locking mechanism, the tape feeder 34 is unlocked and pushed out from the feeder support platform 33, and the connection between the tape feeder 34 and the feeder support platform 33 is released.

As shown in FIG. 7 (A), a barcode reader 56 for reading a barcode 55 attached to the tape feeder 34 housed in the feeder supply section 51A is equipped on the feeder supply section 51A, such that it can be checked whether the tape feeder 34 housing the required components has been supplied from the component storage cabinet 14 without any mistakes. In this case, it is acceptable to provide a tape feeder 34 with a 2D code or a RFID instead of the barcode 55 and to perform recognition of the 2D code or the RFID with a camera or a RFID reader provided on the feeder supply section 51A.

Conversely, with the tray supply unit 52, a tray supply section 52A which is capable of housing multiple component trays 37 and which supplies these component trays 37 to the stocker inside of the housing 35 of the mounter module 12, and a tray collection section 52B which is capable of housing multiple component trays 37 and which collects component trays 37 from the stocker inside of the housing 35 of the mounter module 12, are lined up in the traveling direction of the traveling platform 16.

Each of the component trays 37 housed in the tray supply section 52A is indexed out in the Y-axis direction by a tray indexing mechanism not shown in the figures such that it is supplied to a specified storage shelf of the stocker of the tray type component supply device 22B of the mounter module 12. In the same way, in the tray collection section 52B, a component tray 37 which has become empty is able to be indexed out from the stocker of the tray type component supply device 22B of the mounter module 12 in the Y-axis direction and collected by the tray indexing mechanism which is omitted from the figures.

Here, by making the tray supply section 52A which houses multiple component trays 37 able to be moved up and down, or by using the up and down operation of the stocker of the tray type component supply device 22B, each of the multiple component trays 37 housed in each level of the tray supply section 52A can be supplied to a specified storage shelf of the stocker.

As shown in FIG. 7 (B), a barcode reader 58 for reading a barcode 57 attached to a component tray 37 housed in the tray supply section 52A is equipped on the tray supply section 52A, such that it can be checked whether the component tray 37 housing the required components has been supplied from the component storage cabinet 14 without any mistakes.

As shown in FIG. 3, in order to perform supply of electricity and communication in a contactless manner, respectively attached between each work module 13A/13B and the supply device 15 are: a belt-shaped unit 63 for contactless transmission extending in the X-axis direction on the printer module 11 and the multiple mounter module 12 side; and a head 64 for contactless transmission which faces the unit 63 for contactless transmission on the supply device 15 side. The contactless transmission device 65 includes these unit 63 for contactless transmission and the head 64 for contactless transmission such that electricity can be supplied from the work module 13A/13B side to the supply device 15 side, and the required communication can be performed between the work module 13A/13B side and the supply device 15 side, by the contactless transmission device 65.

With the first embodiment given above, because the multiple component supply members 34 and 37 can respectively be housed in each supply device 15, it is possible to supply components to the multiple mounter modules 12 with one supply device 15. Also, because multiple supply devices 15 are equipped on the first and the second work modules 13Aand 13B respectively, it is possible to supply components to multiple of the mounter modules from the multiple supply devices 15 at the same time.

However, in order to prevent supply devices 15 interfering with each other when the multiple supply devices 15 are removed from the component storage cabinet 14, it is desirable to perform control such that the multiple supply devices 15 are removed from the component storage cabinet 14 simultaneously, and, when component supply work is complete for the multiple mounter modules 12, the multiple supply devices 15 are returned to the component storage cabinet 14 simultaneously.

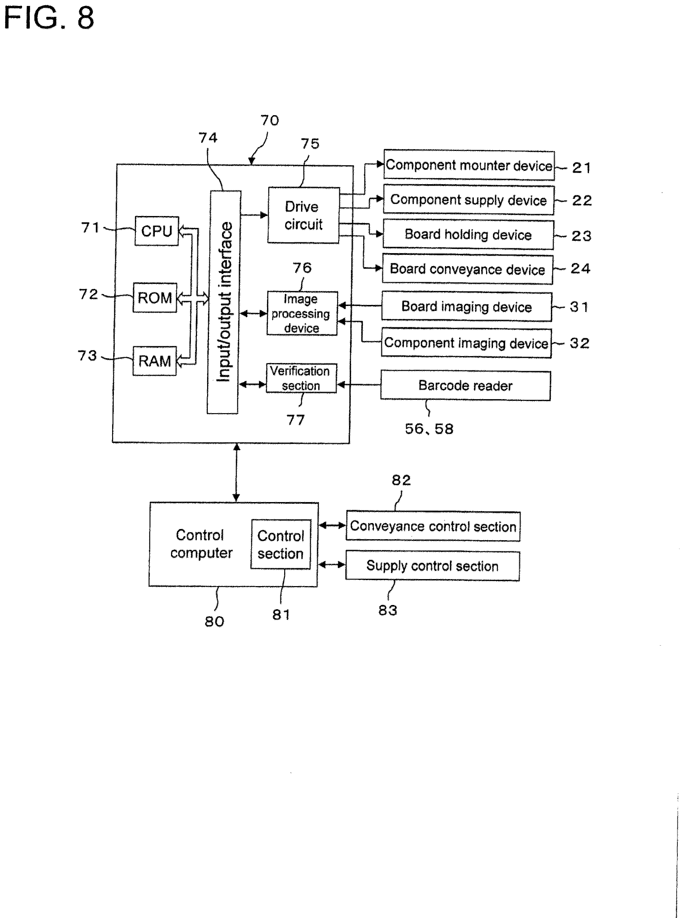

FIG. 8 shows a control device 70 which controls each mounter module 12, and the control device 70 is equipped with CPU 71, ROM 72, and RAM 73 and an input/output interface 74 which is connected to these. Connected to the input/output interface 74 are items such as the component mounter device 21, the component supply device 22, a drive circuit 75 for driving the board holding device 23 and the board conveyance device 24, an image processing device 76 for image processing image data captured by the board imaging device 31 and the component imaging device 32, and a verification section 77 for verifying information read at the barcode readers 56 and 58.

Saved on the ROM 72 of the control device 70 are data such as component model number, dimensions, and quantity of housed components for each serial ID of components housed in the tape feeders 34 and the component trays 37. By this, it is possible to recognize items such as the component model number when the serial ID of a component is acquired by the barcode reader 56 or 58.

A control computer 80 for performing centralized control of the work modules 13A and 13B and the component storage cabinet 14 is connected to the control device 70. The control computer 80 is equipped with a control section 81 for performing centralized control of the first and the second work modules 13Aand 13B, and a conveyance control section 82 for controlling conveyance of the supply devices 15 and a supply control section 83 for controlling supply of the supply device 15 are connected to this control section 81.

Next, component supply operation in the above first embodiment is described. Circuit boards B are conveyed consecutively in the printer module 11 and the mounter modules 12 by the board conveyance device 24, solder is printed onto the conveyed circuit board B in the printer module 11, and components are mounted onto the circuit board B according to a predefined program by the component mounter device 21 in each mounter module 12.

The remaining quantity of components is managed as each component is picked up from a tape feeder 34 or a component tray 37 in each mounter module 12, and when components have nearly run out in a tape feeder 34 or component tray 37, a component supply request is issued to the control computer 80 from the control device 70 of the mounter module 12.

Based on this issued component supply request, an instruction is issued to the operator in the component storage cabinet 14 that supply should be performed of a tape feeder 34 or component tray 37 which houses the component type which is required for component supply, to the feeder supply unit 51 or the tray supply unit 52 of the supply device 15 which is waiting in the component storage cabinet 14.

For example, if a tape feeder 34 housing type A components runs out of components at a certain mounter module 12, a tape feeder 34 housing type A components is set in the feeder supply section 51A of the feeder supply unit 51.

In this case, when the specified tape feeder 34 is set in the feeder supply section 51A, the barcode 55 of the tape feeder 34 is read by the barcode reader 56, and the serial ID of the tape feeder 34 is transmitted to the control computer 80 connected to the component storage cabinet 14. Because component related data for each serial ID is saved in the control computer 80, whether the tape feeder 34 set in the feeder supply section 51A is of the same type as the supply component instructed by the control device 70 of the mounter module 12 is verified by the verification section 77. Supposing that the supply component set in the feeder supply section 51A is incorrect, a verification error is reported to the operator in the component storage cabinet 14.

When a tape feeder 34 housing type A components which should be supplied is set in the feeder supply unit 51, the drive motor 48 provided on the traveling platform 16 of the supply device 15 operates. The pinion 47 which engages with the rack 43 is rotated by the operation of the drive motor 48, and by this, the traveling platform 16 is moved out from the component storage cabinet 14 towards the mounter module 12 which requires component supply, supported and guided along the second guide rail mechanism 42Aand the first guide rail 41A.

Here, information is transmitted between the supply device 15 and the mounter module 12 in a contactless manner by the contactless transmission device 65, and the movement of the supply device 15 to the mounter module 12 which requires component supply is controlled.

When the supply device 15 has been moved to the specified mounter module 12, the drive motor 48 is stopped and the supply device 15 is positioned at a predetermined position with respect to the mounter module 12. In that state, the indexing roller 53 of the feeder indexing mechanism of the feeder supply section 51A of the feeder supply unit 51 is driven in the forward direction such that the tape feeder 34 housing the supply components is indexed towards an empty slot of the feeder support platform 33 of the feeder type component supply device 22A from the feeder supply section 51A.

When the tape feeder 34 is indexed to a predetermined position of an empty slot, the tape feeder 34 is attached to the feeder support platform 33 and the connectors of the tape feeder 34 and the feeder support platform 33 are connected by a locking device which is omitted from the figures.

When a tape feeder 34 housing supply components is attached to the feeder support platform 33, the drive motor 48 is rotated a specified amount such that the traveling platform 16 is moved a specified amount in the X-axis direction. By this, the feeder collection section 51B of the feeder supply unit 51 is positioned at the position which corresponds to the tape feeder 34 which has run out of components. In this state, the tape feeder 34 is unlocked from the feeder support platform 33 by the unlocking of the locking device which is omitted from the figures, then, the indexing roller (53) of the feeder indexing mechanism of the feeder supply unit 51 is reversed such that the tape feeder 34 is collected into the feeder collection section 51B of the feeder supply unit 51 from a slot on the feeder support platform 33.

In this case, it is acceptable for, at first, the tape feeder 34 which has run out of components to be collected in the feeder collection section 51B of the feeder supply unit 51, and then, a tape feeder 34 which should be supplied to be supplied in that empty slot.

In this way, by automatically supplying type A components which have run out to the mounter module 12 from the component storage cabinet 14, just by switching the component supply position to the supply position of a tape feeder 34 which has been newly attached, it is possible to continue production without interrupting mounting work, and personnel reduction and automation are possible.

The supply device 15 for which supply and collection of tape feeders 34 is complete is returned to the component storage cabinet 14, and empty tape feeders 34 are removed from the feeder collection section 51B of the feeder supply unit 51 in the component storage cabinet 14.

In this case, if component supply is necessary at multiple mounter modules 12, multiple tape feeders 34 housing the types of components required at multiple mounter modules 12 are loaded in the feeder supply section 51Aof the feeder supply unit 51, such that it is also possible to perform supply and collection of tape feeders 34 as above while consecutively stopping supply device 15 at the multiple mounter modules 12.

Further, when supplying component trays 37 to mounter modules 12 also, this can be performed in the same manner as supply operation for tape feeders 34. In other words, if an instruction is issued from the control device 70 of the mounter module 12 to the control computer 80 for supply of type B component housed in a certain component tray 37, a component tray 37 housing type B components is set in the tray supply section 52A of the tray supply unit 52 on a supply device 15 which is waiting inside the component storage cabinet 14, and conveyed to the mounter module 12 which requires component supply.

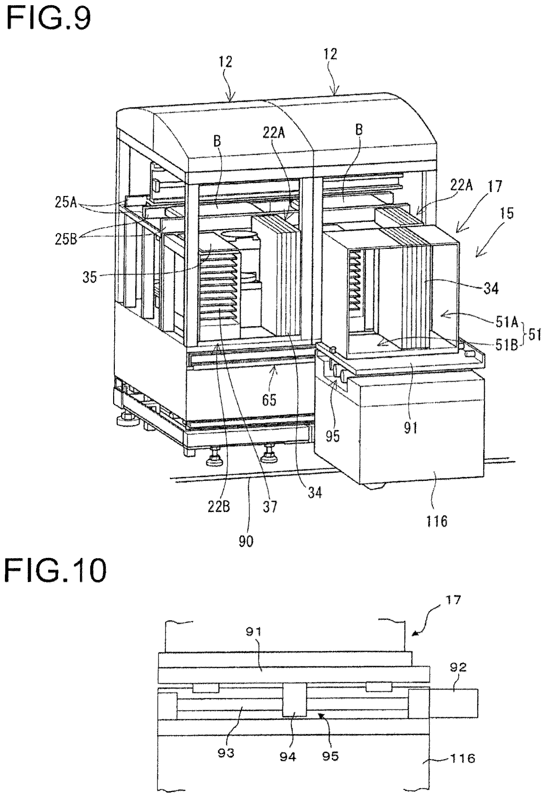

FIG. 9 shows the second embodiment of the present invention, and differences from the first embodiment are that this is an item for which the supply device 15 can be conveyed between the component storage cabinet 14 and each work module 13 by a conveyance means including an unmanned conveyance cart 116. Note that, for the constituent components which are the same as those mentioned for the first embodiment, the same reference symbols are used and descriptions are omitted.

For the second embodiment, multiple unmanned conveyance carts 116 are provided on the floor in front of each work module 13Aand 13B mentioned in the first embodiment, such that they can travel in the X-axis direction, and these multiple unmanned conveyance carts 116 are able to be conveyed between the component storage cabinet 14 and each of the work modules 13 by the magnetic induction effect of a guideline 90 set in the floor. Further, other than in the floor, it is also acceptable to set the guideline 90 on the front of the work modules 13A and 13B.

On the multiple unmanned conveyance carts 116, moving platforms 91 on which the feeder supply unit 51 shown in FIG. 9 or the tray supply unit 52 (refer to FIG. 5) omitted from the figure can be movably set in the X-axis direction, are each guidably supported by a guide mechanism omitted from the figure such that they can each be moved in the X-axis direction. The moving platform 91, as shown in FIG. 10, is such that it can be moved in the X-axis direction by a moving device 95 which includes a ball screw 93 which is moved by a motor 92 and an indexing nut 94 which engages with that ball screw 93.

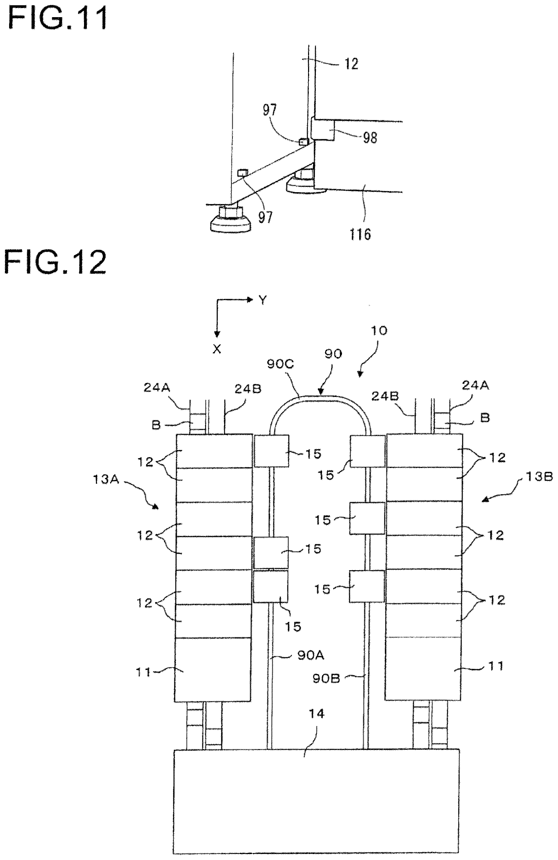

Also, because it is difficult to accurately stop the unmanned conveyance cart 116 in a position with respect to the mounter module 12, as shown in FIG. 11, a pair of positioning pins 97 which comprise a positioning means are provided on the front of the mounter module 12 separated in the X-axis direction such that they can be advanced/retracted, and when the unmanned conveyance cart 116 is stopped at a position corresponding to the mounter module 12 based on the detection signal from a sensor omitted from the figure, the pair of positioning pins 97 are advanced and the stopping position of the unmanned conveyance cart 116 is corrected. By this, it is possible to accurately position the unmanned conveyance cart 116 with respect to the mounter module 12.

In this case, it is good to provide on the unmanned conveyance cart 116 a guide roller 98 which can contact the front of the mounter module 12, and by running the unmanned conveyance cart 116 while the guide roller 98 is constantly contacting the front of the mounter module 12, it is possible to maintain a constant gap between the mounter module 12 and the unmanned conveyance cart 116.

Although not shown, a motor which acts as a traveling drive source is loaded on the unmanned conveyance cart 116, and electric power is supplied to this motor from the work modules 13A/13B side by the contactless transmission device 65 and as such the conveyance of the unmanned conveyance cart 116 is controlled. In this case, it is also acceptable to embed a battery to be used as a motor power source in the unmanned conveyance cart 116, to control conveyance of the unmanned conveyance cart 116 by this battery, and to charge the battery using electric power transmitted in a contactless manner by the contactless transmission device 65 while components are being supplied at each mounter module 12.

For the second embodiment, the supply device 15 is conveyed by the unmanned conveyance cart 116 to a position corresponding to a mounter module 12 which requires component supply, and the position is decided using a sensor or the like which is omitted from the figure. Then, the pair of positioning pins 97 provided in the front of mounter module 12 are moved forward such that the stopping position of the unmanned conveyance cart 116 is finely adjusted in the X-axis direction, and the unmanned conveyance cart 116 is accurately stopped in a position with respect to the mounter module 12.

Here, if the feeder supply unit 51 housing multiple tape feeders 34 as shown in FIG. 9 is loaded on the unmanned conveyance cart 116, the moving platform 91 is moved in the X-axis direction by the moving device 95, and a specified tape feeder (a tape feeder which should be supplied) 34 housed in the feeder supply section 51A is positioned at a position which matches an empty slot in the feeder type component supply device 22A of the mounter module 12, and the tape feeder 34 is attached to the empty slot using a feeder indexing mechanism which is omitted from the figure. Then, the moving platform 91 is moved in the X-axis direction by the moving device 95 and an empty housing section of the feeder collection section 51B is positioned at a position which matches the specified tape feeder (a tape feeder which has run out of components) 34 which should be collected from the feeder type component supply device 22A, and the tape feeder 34 is removed and collected into the feeder collection section 51B by a feeder indexing mechanism which is omitted from the figure.

Further, although not shown in the figure, the same type of tray supply unit 52 shown in FIG. 5 is supported on the above mentioned moving platform 91 on another unmanned conveyance cart 116, and component trays 37 are supplied and collected between the tray type component supply device 22B of the mounter module 12 by this tray supply unit 52.

FIG. 12 shows the third embodiment of the present invention, which includes an endless guideline 90C with the ends of a guideline 90A on the first work module 13A side and a guideline 90B on the second work module 13B side which magnetically guide the unmanned conveyance cart 116 of the supply device 15 connected to each other. With the third embodiment, the supply device 15 removed from the component storage cabinet 14 can be returned to the component storage cabinet 14 via the first work module 13A and the second work module 13B. Note that, for the constituent components which are the same as those mentioned for the first embodiment, the same reference symbols are used and descriptions are omitted.

It follows that, according to the third embodiment, even if there are multiple supply devices 15, because there is no danger of a supply device 15 removed from the component storage cabinet 14 interfering with a supply device 15 to be returned to the component storage cabinet 14, it is not necessary to remove the multiple supply devices 15 from the component storage cabinet 14 simultaneously as mentioned in the first embodiment, and it is possible to remove the supply devices 15 consecutively based on component supply requests. Further, multiple component supply members 34 and 37 housing components which should be supplied at each mounter module 12 of the first and the second work modules 13Aand 13B are loaded on one supply device 15, so it is also possible to supply components consecutively to each mounter module 12 of the first and the second work modules 13A and 13B, making it possible to improve the efficiency of component supply.

Further, the method for returning the supply device 15 removed from the component storage cabinet 14 to the component storage cabinet 14 via the first work module 13A and the second work module 13B is not restricted to the unmanned conveyance cart 116, and it is also possible to apply the traveling of the traveling platform 16 mentioned for the first embodiment. In this case, this is possible by the end sections of two rows of the first guide rail mechanisms 54A and 54B being connected to each other by an arc shaped guide rail mechanism, and an arc shaped gear section which engages with the pinion 47 being provided on this arc shaped guide rail mechanism such that it connects with the rack 43.

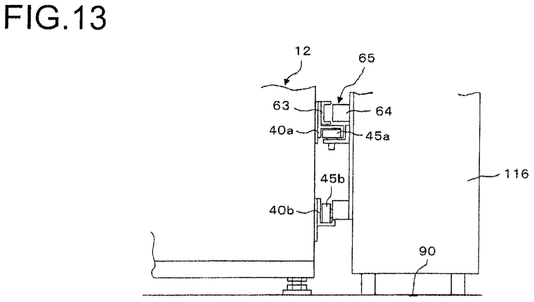

FIG. 13 shows the fourth embodiment of the present invention, which while using the unmanned conveyance cart 116, guides the unmanned conveyance cart 116 by the upper section and the lower section guide rails 40a and 40b mentioned in the first embodiment, and which is otherwise the same as the item mentioned in the first embodiment. According to this, the positional accuracy in the Y-axis direction of the unmanned conveyance cart 116 which is positioned at each mounter module 12 can be improved.

According to the above embodiments, provided are: the component storage cabinet 14 which stores multiple component supply members 34 and 37 housing many components; the supply device 15 which is capable of traveling between the component storage cabinet 14 and multiple mounter modules 12 which supports component supply members 34 and 37 and supplies component supply members 34 and 37 to the multiple mounter modules 12 and collects the component supply members 34 and 37 from the multiple mounter modules 12; the conveyance means 49 which conveys the supply device 15 between the component storage cabinet 14 and the multiple mounter modules 12; the contactless transmission device 65 which transmits a signal in a contactless manner between the multiple mounter modules 12 and the supply device 15; and the verification section 77 which reads and verifies the ID of the component supply members 34 and 37 which are supplied between the mounter module 12 and the supply device 15.

According to the above configuration, even if components run out in the component supply device 22 of the mounter module 12, the required components can be supplied automatically and efficiently by supply device 15 which runs between the component storage cabinet 14 and the mounter module 12 and supports the component supply member 34 or 37 which has run out of components, and personnel reduction and automation are possible.

By this, it is fine if operators just supply the required component supply members 34 and 37 to the supply device 15 inside the component storage cabinet 14, and by automating the supply of component supply members 34 and 37 to the supply device 15 at the component storage cabinet 14, component supply without operators is possible.

According to the above embodiments, because the supply device 15 can support multiple component supply members 34 and 37, it is possible to supply multiple component supply members 34 and 37 to the mounter module 12 from the supply device 15 which is supporting the multiple component supply members 34 and 37.

According to the above embodiments, because the supply device 15 can support various types of component supply members 34 and 37 housing different types of components, it is possible to supply various types of component supply members 34 and 37 housing different types of components to multiple mounter modules 12 from the supply device 15 which is supporting various types of component supply members 34 and 37 housing different types of components.

According to the above embodiments, the conveyance means 49 includes guide rails 40a and 40b provided on the front of the multiple mounter modules and the rack (chain) 43 parallel to the guide rails 40a and 40b; and the follower rollers 45a and 45b which engage with the guide rails 40a and 40b, the pinion (sprocket wheel) 47 which engages with the rack 43, and the drive motor 48 for rotating the pinion 47 provided on the supply device 15 side.

By this, it is possible to convey the supply device 15 via the pinion 47 and the rack 43 by the rotation of the drive motor 48, and further, the supply device 15 can be accurately positioned in a position corresponding to the mounter module 12 by the rotation stopping accuracy of the drive motor 48.

According to the above embodiments, because the contactless transmission device 65 can perform supply of electricity from multiple mounter modules 12 to the supply device 15 in a contactless manner, it is possible to supply the appropriate electric power to the motor and so on the supply device 15 side from the mounter module 12 side.

According to the above embodiments, because the supply device 15 includes the unmanned conveyance cart 116 which can travel on the floor guided by the guideline 90 set along the multiple mounter modules 12, and the supply unit 17 upon which component supply members 34 and 37 loaded on the unmanned conveyance cart 116 are supported such that they can be supplied and collected, it is possible to create a component mounting system which can automate component supply fairly easily by arranging the unmanned conveyance cart and the guideline 90 without making large modifications to the mounter module 12.

According to the above embodiments, because the moving platform 91 which moves the supply unit 17 in the traveling direction of the unmanned conveyance cart 116 with respect to the unmanned conveyance cart 116 is provided between the unmanned conveyance cart 116 and the supply unit 17, even when the X-axis direction position of the supply unit 17 with respect to the mounter module 12 changes, this can be easily handled by the movement of the moving platform 91.

According to the above embodiments, because a positioning means (the positioning pins 97) which positions the unmanned conveyance cart 116 in the traveling direction is provided on the front of the multiple mounter modules 12, the stopping position of the unmanned conveyance cart 116 which is stopped in a position corresponding to the mounter module 12 can be corrected by the positioning means. By this, even for the unmanned conveyance cart 116 which is difficult to accurately stop in a position with respect to the mounter module 12, it becomes easy to accurately stop in a position with respect to the mounter module 12.

According to the above embodiments, because the guide rails 40a and 40b are each provided on the front of the multiple mounter modules 12 and the follower rollers 45a and 45b which engage with these guide rails 40a and 40b are supported on the unmanned conveyance cart 116, the unmanned conveyance cart 116 which runs on the floor is guided by the guide rails 40a and 40b and the positional accuracy of the unmanned conveyance cart 116 positioned at the mounter module 12 can be improved in the direction perpendicular to the traveling direction.

According to the above embodiments, multiple component supply members (tape feeders 34 or component trays 37) can be supported on the supply unit 17, but it is also acceptable for a single component supply member to be supported on the supply unit 17.

Also, according to the above embodiments, an example was given in which two rows of work modules 13Aand 13B were arranged with a gap in the X-axis direction, but it is also possible to have three rows or more, or a single row, of work modules.

Embodiments of the present invention were described above, but the present invention is not limited to the above embodiments, and various forms which do not extend beyond the range of the object of the present invention as given in the claims are possible.

### Industrial Applicability

The present invention of a component mounting system is appropriate for use as an item for supplying components by a supply device which can travel between a component storage cabinet and multiple mounter modules.

### Reference Signs List

10: Component mounting system; 12: Mounter module; 13: Work module; 14: Component storage cabinet; 15: Supply device; 16: Traveling platform; 17: Supply unit; 34: Tape feeder; 37: Tray; 41A, 41B: Guide rail mechanism; 43: First engaging body; 47: Second engaging body; 48: Drive motor; 49: Conveyance means; 51: Feeder supply unit; 52: Tray supply unit; 65: Contactless transmission device; 70: Control device; 77: Verification section; 80: Control computer.

## Claims

1. A component mounting system at which multiple mounter modules (12), each equipped with a mounting head (30), are arranged along a conveyance direction of circuit boards, comprising:
a component storage cabinet (14) which is configured to store multiple component supply members (34, 37), each housing many components;
a supply device (15) which is capable of traveling between the component storage cabinet (14) and the multiple mounter modules (12), and which is configured to hold at least one of the component supply members (34, 37) and to supply a respective component supply member (34, 37) to a respective one of the multiple mounter modules (12) and to collect a respective component supply member (34, 37) from the respective one of the multiple mounter modules (12);
a conveyance means (49) which is configured to convey the supply device (15) between the component storage cabinet (14) and the multiple mounter modules (12);
**characterized in that**
the component mounting system further comprises a verification section (77) which is configured to read and verify the ID of the respective component supply member (34, 37) which is supplied to the respective one of the mounter modules (12) from the supply device (15),
wherein
the conveyance means (49) is configured to include guide rails (40a, 40b) provided on the front side of the multiple mounter modules (12), and follower rollers (45a, 45b) which are provided on the supply device side and which are configured to engage with the guide rails (40a, 40b).

2. The component mounting system according to claim 1 wherein the supply device (15) is configured to hold multiple of the component supply members (34, 37).

3. The component mounting system according to claim 1 wherein the supply device (15) is configured to hold various types of the component supply members (34, 37) which house components of different types.

4. The component mounting system according to any of claims 1 to 3 wherein the conveyance means (49) includes a first engaging body (43) parallel to the guide rails (40a, 40b), a second engaging body (47) which engages with the first engaging body (43), and a drive motor (48) for rotating the second engaging body (47).

5. The component mounting system according to claim 1 wherein the supply device (15) includes an unmanned conveyance cart (116) which is configured to be guided by a guideline (90) constructed along the multiple mounter modules (12) and can travel on the floor, and a supply unit (17) on which at least one of the component supply members (34, 37) can be held such that it can be supplied and collected and which is loaded on the unmanned conveyance cart (116).

6. The component mounting system according to claim 5 wherein a moving means (95) for moving the supply unit in the traveling direction of the unmanned conveyance cart (116) with respect to the unmanned conveyance cart (116) is provided between the unmanned conveyance cart (116) and the supply unit.

7. The component mounting system according to claim 5 or 6 wherein a positioning means (97) adapted to accurately position the unmanned conveyance cart (116) in the traveling direction is provided on the front side of the multiple mounter modules (12).

8. The component mounting system according to any of the claims 5 to 7 wherein the follower rollers (45a, 45b) are provided on the unmanned conveyance cart (116).

## Patentansprüche

1. Komponentenmontagesystem, bei welchem mehrere Montagemodule (12), die jeweils mit einem Montagekopf (30) ausgestattet sind, entlang einer Förderrichtung von Leiterplatten angeordnet sind, umfassend:
einen Komponentenlagerschrank (14), der konfiguriert ist, mehrere Komponentenzuführelemente (34, 37) zu lagern, die jeweils viele Komponenten aufnehmen;
eine Zuführvorrichtung (15), die in der Lage ist, zwischen dem Komponentenlagerschrank (14) und den mehreren Montagemodulen (12) zu verfahren, und die konfiguriert ist, mindestens eines der Komponentenzuführelemente (34, 37) zu halten und ein jeweiliges Komponentenzuführelement (34, 37) zu einem jeweiligen der mehreren Montagemodule (12) zu liefern und konfiguriert ist, ein jeweiliges Komponentenzuführelement (34, 37) von dem jeweiligen der mehreren Montagemodule (12) einzusammeln;
eine Fördereinrichtung (49), die konfiguriert ist, die Zuführvorrichtung (15) zwischen dem Komponentenlagerschrank (14) und den mehreren Montagemodulen (12) zu fördern;
**dadurch gekennzeichnet, dass** das Komponentenmontagesystem weiter umfasst einen Verifikationsabschnitt (77), der konfiguriert ist, die ID des jeweiligen Komponentenzuführelements (34, 37), das von der Zuführvorrichtung (15) zu dem jeweiligen der Montagemodule (12) geliefert wird, zu lesen und zu verifizieren,
wobei
die Fördereinrichtung (49) konfiguriert ist, um Führungsschienen (40a, 40b) zu umfassen, die an der Vorderseite der mehreren Montagemodule (12) bereitgestellt sind, und Mitläuferrollen (45a, 45b), die auf der Zuführvorrichtungsseite bereitgestellt sind und die konfiguriert sind, mit den Führungsschienen (40a, 40b) in Eingriff zu stehen.

2. Das Komponentenmontagesystem gemäß Anspruch 1, wobei die Zuführvorrichtung (15) konfiguriert ist, mehrere der Komponentenzuführelemente (34, 37) zu halten.

3. Das Komponentenmontagesystem gemäß Anspruch 1, wobei die Zuführvorrichtung (15) konfiguriert ist, verschiedene Typen der Komponentenzuführelemente (34, 37) zu halten, welche Komponenten unterschiedlicher Typen aufnehmen.

4. Das Komponentenmontagesystem gemäß einem der Ansprüche 1 bis 3, wobei die Fördereinrichtung (49) einen ersten Eingriffskörper (43) parallel zu den Führungsschienen (40a, 40b), einen zweiten Eingriffskörper (47), der mit dem ersten Eingriffskörper (43) in Eingriff steht, und einen Antriebsmotor (48) zum Drehen des zweiten Eingriffskörpers (47) umfasst.

5. Das Komponentenmontagesystem gemäß Anspruch 1, wobei die Zuführvorrichtung (15) einen unbemannten Förderwagen (116) umfasst, der konfiguriert ist, um von einer Leitlinie (90) geleitet zu werden, die entlang der mehreren Montagemodule (12) eingerichtet ist und auf dem Boden fahren kann, und eine Zuführeinheit (17), auf welcher mindestens eines der Komponentenzuführelemente (34, 37) so gehalten werden kann, dass es geliefert und eingesammelt werden kann und die auf dem unbemannten Förderwagen (16) aufgeladen ist.

6. Das Komponentenmontagesystem gemäß Anspruch 5, wobei eine Bewegungseinrichtung (95) zur Bewegung der Zuführeinheit in der Fahrrichtung des unbemannten Förderwagens (116) bezüglich des unbemannten Förderwagens (116) zwischen dem unbemannten Förderwagen (116) und der Zuführeinheit bereitgestellt ist.

7. Das Komponentenmontagesystem gemäß Anspruch 5 oder 6, wobei eine Positioniereinrichtung (97), die eingerichtet ist, den unbemannten Förderwagen (116) in der Fahrrichtung genau zu positionieren, an der Vorderseite der mehreren Montagemodule (12) bereitgestellt ist.

8. Das Komponentenmontagesystem gemäß einem der Ansprüche 5 bis 7, wobei die Mitläuferrollen (45a, 45b) an dem unbemannten Förderwagen (116) bereitgestellt sind.

## Revendications

1. Système de montage de composants dans lequel plusieurs modules de montage (12), chacun équipé d'une tête de montage (30), sont disposés le long d'une direction de transport de cartes de circuits imprimés, comprenant :
une armoire de stockage de composants (14) qui est configurée pour stocker plusieurs éléments d'alimentation en composants (34, 37), chacun abritant de nombreux composants ;
un dispositif d'alimentation (15) qui est capable de se déplacer entre l'armoire de stockage de composants (14) et les plusieurs modules de montage (12), et qui est configuré pour tenir au moins un des éléments d'alimentation en composants (34, 37) et pour fournir un élément d'alimentation en composants (34, 37) respectif à l'un respectif des plusieurs modules de montage (12) et pour collecter un élément d'alimentation en composants (34, 37) respectif à partir de l'un respectif des plusieurs modules de montage (12) ;
un moyen de transport (49) qui est configuré pour transporter le dispositif d'alimentation (15) entre l'armoire de stockage de composants (14) et les plusieurs modules de montage (12) ;
**caractérisé en ce que** le système de montage de composants comprend en outre une section de vérification (77) qui est configurée pour lire et vérifier l'ID de l'élément d'alimentation en composants (34, 37) respectif qui est fourni à l'un respectif des modules de montage (12) à partir du dispositif d'alimentation (15),
dans lequel le moyen de transport (49) est configuré pour inclure des rails de guidage (40a, 40b) prévus sur le côté avant des plusieurs modules de montage (12), et des rouleaux suiveurs (45a, 45b) qui sont prévus sur le côté du dispositif d'alimentation et qui sont configurés pour s'engager dans les rails de guidage (40a, 40b).

2. Système de montage de composants selon la revendication 1, dans lequel le dispositif d'alimentation (15) est configuré pour contenir plusieurs des éléments d'alimentation en composants (34, 37) .

3. Système de montage de composants selon la revendication 1, dans lequel le dispositif d'alimentation (15) est configuré pour contenir divers types d'éléments d'alimentation en composants (34, 37) qui abritent des composants de différents types.

4. Système de montage de composants selon l'une quelconque des revendications 1 à 3, dans lequel le moyen de transport (49) inclut un premier corps d'engagement (43) parallèle aux rails de guidage (40a, 40b), un deuxième corps d'engagement (47) qui s'engage avec le premier corps d'engagement (43), et un moteur d'entraînement (48) pour faire tourner le deuxième corps d'engagement.

5. Système de montage de composants selon la revendication 1, dans lequel le dispositif d'alimentation (15) inclut un chariot de transport sans équipage (116) qui est configuré pour être guidé par une ligne directrice (90) construite le long des plusieurs modules de montage (12) et peut se déplacer sur le sol, et une unité d'alimentation (17) sur laquelle au moins un des éléments d'alimentation en composants (34, 37) peut être maintenu de sorte qu'il puisse être fourni et collecté et qui est chargé sur le chariot de transport sans équipage (116).

6. Système de montage de composants selon la revendication 5, dans lequel un moyen de déplacement (95) pour déplacer l'unité d'alimentation dans la direction de déplacement du chariot de transport sans équipage (116) par rapport au chariot de transport sans équipage (116) est prévu entre le chariot de transport sans équipage (116) et l'unité d'alimentation.

7. Système de montage de composants selon la revendication 5 ou 6, dans lequel un moyen de positionnement (97) adapté pour positionner avec précision le chariot de transport sans équipage (116) dans la direction de déplacement est prévu sur le côté avant des plusieurs modules de montage (12).

8. Système de montage de composants selon l'une quelconque des revendications 5 à 7, dans lequel les rouleaux suiveurs (45a, 45b) sont prévus sur le chariot de transport sans équipage (116).
